# EUROPEAN PATENT APPLICATION

(11) **EP 2 124 342 A1**
(43) Date of publication of application: **25.11.2009**
(21) Application number: 08711039.1
(22) Date of filing: 08.02.2008
(51) Int. Cl.: H03L 7/107, H03L 7/093

(54) **PLL FREQUENCY SYNTHESIZER**

(30) Priority: 07.03.2007 JP 2007057692
(71) Applicant: Thine Electronics, Inc., Tokyo 103-0023 (JP)
(72) Inventor: SUGANO, Takayuki, Tokyo 103-0023 (JP); YATSUDA, Senichiro, Tokyo 103-0023 (JP); OHTSUKA, Shigeki, Tokyo 103-0023 (JP); CHIBA, Yutaka, Tokyo 103-0023 (JP)
(74) Representative: Moir, Elizabeth
(86) International application number: PCT/JP2008/052160
(87) International publication number: WO 2008/108139

(57) **Abstract**

A PLL frequency synthesizer 1 according to one embodiment of the present invention is provided with a frequency divider 30, a phase comparator 40, a charge pump 50, a loop filter 60, a voltage controlled oscillator 70, and a changeover switch (within the switching unit 80). The loop filter 60 has a reference potential on a semiconductor substrate as a ground potential, and the changeover switch is formed on the semiconductor substrate 2 and switches connection between an intermediate node of the loop filter 60 and the reference potential on the semiconductor substrate 2 to switch the time constant of the loop filter 60.

## Description

### Technical Field

The present invention relates to a PLL frequency synthesizer.

### Background Art

A TDMA system such as GSM with a high frequency utilization efficiency has been used in cellular telephone systems with increased communication volume. In the TDMA system, a plurality of data are arranged in a time sequence via guard bands, and different frequencies are allocated to different data. As a result, a PLL frequency synthesizer that is used in a cellular phone ground station is required to switch frequencies rapidly within a guard time period. Patent Document 1 describes a PLL frequency synthesizer of this type.

The PLL frequency synthesizer described in Patent Document 1 is provided with a changeover switch that switches a loop bandwidth of a loop filter, and when the frequency is switched, the loop bandwidth is temporarily broadened and the frequency is rapidly switched. Further, this PLL frequency synthesizer narrows down the loop bandwidth and reduces the spurious noise after the frequency has been switched.
Patent Document 1: Japanese Patent Application Laid-open No. 2004-140688

### Disclosure of the Invention

### Problems to be Solved by the Invention

In order to enable miniaturization and increase speed, it is preferred that the PLL frequency synthesizer be formed as an integrated circuit on a single semiconductor substrate. However, although a changeover switch is easy to form on a semiconductor substrate, a large mounting area is necessary to form a capacitive element of the loop filter on the semiconductor substrate. As a result, the loop filter is difficult to form on the semiconductor substrate.

Accordingly, in the PLL frequency synthesizer, the capacitive element, first resistive element, and second resistive element constituting the loop filter are provided outside the semiconductor. For this purpose, the capacitive element and second resistive element are connected in order in series between an output terminal of the charge pump and a ground potential outside the semiconductor. An intermediate node between the capacitive element and second resistive element is connected to the ground potential inside the semiconductor via the first resistive element and changeover switch formed on the semiconductor substrate, in the order of description.

The ground potential inside the semiconductor differs from the ground potential outside the semiconductor due to the effect of resistive components such as wiring metal or bonding wire and the semiconductor substrate (substrate). For this reason, in the conventional PLL frequency synthesizer, when the changeover switch is switched ON and OFF, the output voltage of the loop filter, that is, the control voltage of the voltage controlled oscillator fluctuates due to the difference in potential between the ground potential outside the semiconductor and the ground potential inside the semiconductor. As a result, the frequency of the output signal fluctuates.

Thus, in the conventional PLL frequency synthesizer, after the bandwidth of the loop filter has been broadened and the frequency has been rapidly drawn to the desired frequency, the frequency of the output signal shifts when the switching is made to a narrow-bandwidth loop filter. Because the frequency is drawn from this shifted frequency to the desired frequency in a state with a narrow loop bandwidth, the time required to lock the frequency at the desired frequency is difficult to shorten.

Accordingly, it is an object of the present invention to provide a PLL frequency synthesizer in which rapid frequency switching is enabled by reducing frequency fluctuations during bandwidth switching of the loop filter.

### Means for Solving the Problem

A PLL frequency synthesizer in accordance with the present invention includes: (1) a voltage controlled oscillator; (2) a frequency divider that frequency divides an output of the voltage controlled oscillator; (3) a phase comparator that inputs an output signal of the frequency divider and a reference signal; (4) a charge pump that generates a charge-discharge current in response to an output signal of the phase comparator; (5) a loop filter that is connected between an output terminal of the charge pump and a control terminal of the voltage controlled oscillator and has a reference potential on a semiconductor substrate as a ground potential; and (6) a changeover switch that is formed on the semiconductor substrate and switches connection between an intermediate node of the loop filter and the reference potential on the semiconductor substrate in order to switch a time constant of the loop filter.

With such a PLL frequency synthesizer, because the loop filter has a reference potential on a semiconductor substrate (for example, a ground potential on the semiconductor substrate) as a ground potential, and the changeover switch switches connection between an intermediate node of the loop filter and the reference potential on the semiconductor substrate, the ground potential of the loop filter is the reference potential on the semiconductor substrate when the changeover switch is ON and OFF. Therefore, when the changeover switch is switched ON and OFF, voltage fluctuations of the control signal can be reduced and frequency fluctuations of the output signal can be reduced. Therefore, with such a PLL frequency synthesizer, frequency fluctuations occurring when the time constant of the loop filter is increased after the frequency has been drawn can be reduced and frequency switching can be rapidly conducted.

It is preferred that the loop filter include a first resistive element, and a capacitive element and a second resistive element that are connected in order in series between an output terminal of the charge pump and a reference potential wiring on the semiconductor substrate; the first resistive element be connected in series to the changeover switch; and a series circuit of the first resistive element and the changeover switch be connected in series between the intermediate node, located between the capacitive element and the second resistive element, and the reference potential wiring on the semiconductor substrate.

Further, it is preferred that the loop filter have a capacitive element, a first resistive element, and a second resistive element connected in order in series between an output terminal of the charge pump and a reference potential wiring on the semiconductor substrate; and the changeover switch be connected in series between the intermediate node, located between the first resistive element, and the second resistive element and the reference potential wiring on the semiconductor substrate.

The above-described PLL frequency synthesizer preferably further includes a matching switch that is formed on the semiconductor substrate and connected in series between the second resistive element and the reference potential wiring on the semiconductor substrate, wherein an impedance of the matching switch is substantially equal to an impedance of the changeover switch.

With such a configuration, the voltage drop in the changeover switch and the voltage drop in the matching switch are substantially identical. Therefore, when the changeover switch is switched ON and OFF, voltage fluctuations of the control signal can be further reduced. As a result, frequency fluctuations of the output signal can be further reduced.

It is preferred that the changeover switch and the matching switch be transistors; and a transistor size of the matching switch be equal to a transistor size of the changeover switch.

With such a configuration, the impedance of the matching switch can be easily made equal to the impedance of the changeover switch.

The above-described PLL frequency synthesizer preferably further includes a matching impedance element that is formed on the semiconductor substrate and connected in series between the second resistive element and the reference potential wiring on the semiconductor substrate, wherein an impedance of the matching impedance element is substantially equal to an impedance of the changeover switch.

With such a configuration, the voltage drop in the changeover switch is substantially equal to the voltage drop in the matching impedance element. Therefore, when the changeover switch is switched ON and OFF, voltage fluctuations of the control signal can be further reduced. As a result, frequency fluctuations of the output signal can be further reduced.

### Effect of the Invention

The present invention makes it possible to obtain a PLL frequency synthesizer in which frequency switching can be rapidly performed by reducing frequency fluctuations during bandwidth switching of the loop filter.

### Brief Description of the Drawings

FIG. 1 is a circuit diagram illustrating a PLL frequency synthesizer of the first embodiment of the present invention.
FIG. 2 is a circuit diagram illustrating a loop filter and a changeover switch in FIG. 1.
FIG. 3 shows frequency variations of an output signal during frequency switching.
FIG. 4 shows a spectrum of an output signal.
FIG. 5 is a circuit diagram illustrating a loop filter and a switching unit in the conventional PLL frequency synthesizer.
FIG. 6 shows frequency transition in an output signal during frequency switching and after frequency switching.
FIG. 7 is a circuit diagram showing a simulation circuit of the loop filter and switching unit of the first embodiment.
FIG. 8 is a circuit diagram of a simulation circuit of the conventional loop filter 60X and switching unit 80X.
FIG. 9 shows a signal voltage in the loop filter and changeover unit of the first embodiment and the conventional loop filter and changeover unit during switching of the changeover switch.
FIG. 10 is a circuit diagram illustrating the loop filter and changeover switch of the second embodiment.

### Explanation of Reference Numerals

- 1, 1A: PLL frequency synthesizers
- 2: semiconductor substrate
- 10: reference oscillator
- 30: frequency divider
- 40: phase comparator
- 50: charge pump
- 60, 60A: loop filter
- 61, 62: capacitive element
- 63: first resistive element
- 64: second resistive element
- 70: voltage controlled oscillator
- 80, 80A: switching unit
- 81: changeover switch
- 82: matching switch
- 82A: matching impedance element
- 90: control circuit
- A: intermediate node
- GND1: ground potential outside the semiconductor (reference potential)
- GND2: ground potential of semiconductor substrate (reference potential)

### Best Mode for Carrying out the Invention

The preferred embodiment of the present invention will be described below in greater details with reference to the drawings. In the drawings, like or corresponding elements are assigned with like reference symbols.

### [First Embodiment]

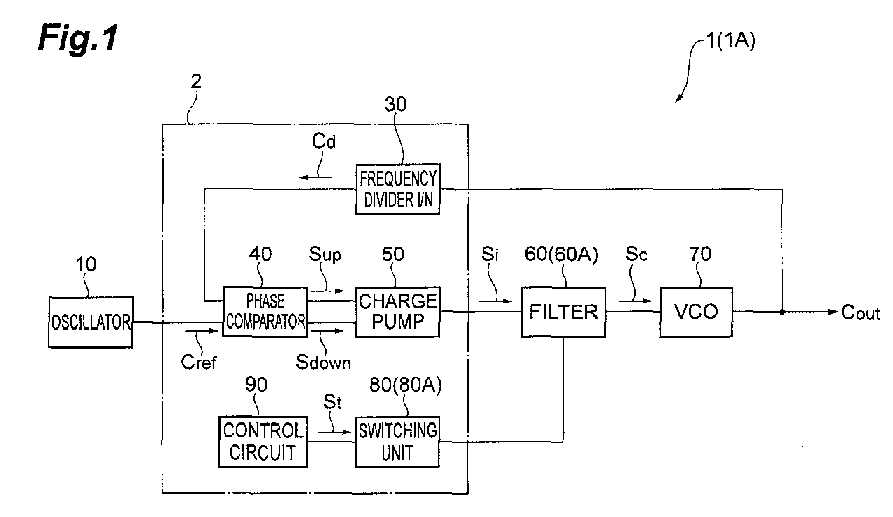

FIG. 1 is a circuit diagram illustrating a PLL frequency synthesizer according to the first embodiment of the invention. The PLL frequency synthesizer 1 shown in FIG. 1 is provided with a reference oscillator 10, a frequency divider 30, a phase comparator 40, a charge pump 50, a loop filter 60, a voltage controlled oscillator (VCO) 70, a switching unit 80, and a control circuit 90. In the present embodiment, the frequency divider 30, phase comparator 40, charge pump 50, switching unit 80, and control circuit 90 are formed as an integrated circuit on a semiconductor substrate 2, and the reference oscillator 10, loop filter 60, and VCO 70 are provided outside the semiconductor substrate 2. For example, a Si substrate, a GaAs substrate, and an InP substrate can be used as the semiconductor substrate 2.

The reference oscillator 10 is, for example, a quartz oscillator and generates a reference signal Cref with a frequency that has been stabilized to a high degree of accuracy. The reference oscillator 10 outputs the reference signal Cref to one input terminal of the phase comparator 40.

The frequency divider 30 generates a frequency divided signal Cd obtained by dividing an output signal Cout from a VCO 70 by N (N is an integer of equal to or larger than 2). The frequency divider 30 outputs the frequency divided signal Cd to the other input terminal of the phase comparator 40. By changing the frequency division ration 1/N of the divider 30, it is possible to change the frequency of the output signal Cout.

The phase comparator 40 generates comparison signals Sup, Sdown corresponding to a phase difference between the reference signal Cref from the reference oscillator 10 and the frequency division signal Cd from the frequency divider 30. For example, when the frequency of the frequency division signal Cd is lower than the frequency of the reference signal Cref, that is, when the phase of the frequency division signal Cd is delayed with respect to the phase of the reference signal Cref, the phase comparator 40 generates the comparative signal Sup having a pulse width corresponding to the phase difference between the frequency division signal Cd and the reference signal Cref. When the frequency of the frequency division signal Cd is higher than the frequency of the reference signal Cref, that is, when the phase of the frequency division signal Cd advances with respect to the phase of the reference signal Cref, the phase comparator 40 generates the comparative signal Sdown having a pulse width corresponding to the phase difference between the frequency division signal Cd and the reference signal Cref. The phase comparator 40 outputs the comparison signals Sup, Sdown to the charge pump 50.

The charge pump 50 generates a charge-discharge current Si in response to the comparison signals Sup, Sdown from the phase comparator 40. For example, in a case where the charge pump 50 receives the comparison signal Sup, a charge current Si having a pulse width corresponding to the pulse width of the comparison signal Sup is supplied to a capacitive element in a loop filter 60, and in a case where the comparison signal Sdown is received, a discharge current Si having a pulse width corresponding to the pulse width of the comparison signal Sdown is received from the capacitive element in the loop filter 60.

The loop filter 60 generates a control signal Sc having a voltage value corresponding to the charge-discharge current Si from the charge pump 50. The loop filter 60 will be described below in greater detail. The loop filter 60 outputs the control signal Sc to a control terminal of the VCO 70.

The VCO 70 generates an output signal Cout having a frequency corresponding to a voltage value of the control signal Sc from the loop filter 60.

The switching unit 80 switches a time constant of the loop filer 60 in response to a switching signal St1 from the control circuit 90. The switching unit 80 will be described below in greater details.

The control circuit 90 generates a switching signal St1 that causes the decrease in the time constant of the loop filter 60 when the frequency of the output signal Cout is switched, and generates a switching signal St1 that causes the increase in the time constant of the loop filter 60 after the frequency of the output signal Cout has been drawn to the desired frequency level. In other words, the control circuit 90 controls the switching unit 80 so that a loop bandwidth of the loop filter 60 is broadened when the frequency of the output signal Cout is switched and so that the loop bandwidth of the loop filter 60 is narrowed after the frequency of the output signal Cout has been drawn to the desired frequency level.

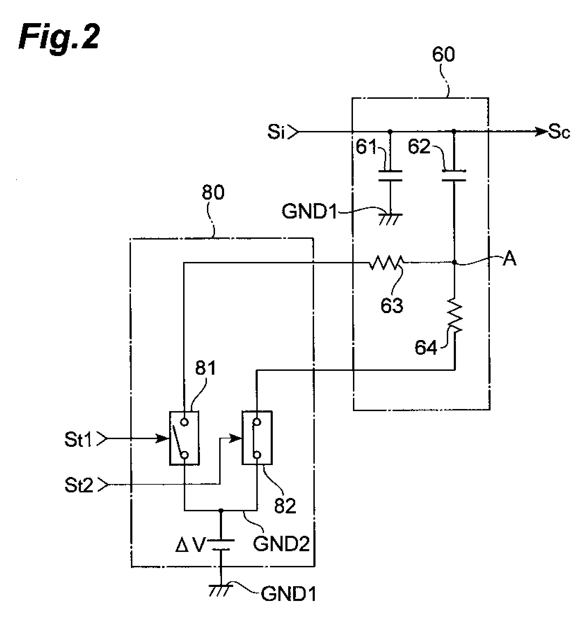

The loop filter 60 and switching unit 80 will be described below in greater detail. FIG. 2 is a circuit diagram showing the loop filter 60 and switching unit 80.

The loop filter 60 has capacitive elements 61, 62, a first resistive element 63, and a second resistive element 64. The capacitive element 61 is connected between an output terminal of the charge pump 50, a control terminal of the VCO 70 and a ground potential (reference potential) GND1 outside the semiconductor. The capacitive element 62 and second resistive element 64 are connected in order in series between the output terminal of the charge pump 50, control terminal of the VCO 70 and the switching unit 80. The first resistive element 63 is connected between the switching unit 80 and an intermediate node A located between the capacitive element 62 and second resistive element 64.

As shown in FIG. 2, the switching unit 80 has a changeover switch 81 and a matching switch 82. The changeover switch 81 is connected between a terminal of the first resistive element 63 other than the terminal connected to the node A and a ground potential (reference potential) GND2 wiring on the semiconductor substrate and conducts ON/OFF switching correspondingly to the voltage value of the switching signal St1 from the control circuit 90. More specifically, the changeover switch 81 is ON when the frequency of the output signal Cout is switched and OFF after the frequency of the output signal Cout has been switched (after the frequency has been drawn to the desired frequency level).

The ground potential GND2 on the semiconductor substrate as referred to herein is a ground potential of an integrated circuit formed on the semiconductor substrate 2, for example, a ground potential on the surface side of the semiconductor substrate 2 where the circuit has been formed. The ground potential GND1 outside the semiconductor substrate as referred to herein is a ground potential of a circuit formed outside the semiconductor substrate 2 or a ground potential of the semiconductor substrate 2, for example, a ground potential on the rear surface side of the semiconductor substrate 2.

The matching switch 82 is connected between the terminal of the second resistive element 64 other than the terminal connected to the node A and the ground potential GND2 wiring on the semiconductor substrate and is normally ON correspondingly to the voltage value of the switching signal St2 from the control circuit 90. In the present embodiment, the changeover switch 81 and matching switch 82 are respective transistors, and the transistor size of the matching switch 82 is substantially identical to the transistor size of the changeover switch 81. Thus, the impedance of the matching switch 82 is substantially identical to the impedance of the changeover switch 81.

The transistor size as referred to herein is a ratio of a gate width to a gate length in a case of a field-effect transistor, and a cross section area of emitter, that is, a value corresponding to a maximum emitter current (maximum collector current + maximum base current) in a case of bipolar transistor.

The operation of the PLL frequency synthesizer of the first embodiment will be explained below. A case in which the frequency f1 of the output signal Cout is switched to the frequency f2 will be explained below.

First, the division ratio 1/N of the frequency divider 30 is changed and the frequency of the frequency division signal Cd is changed. As a result, comparison signals Sup, Sdown having a pulse width corresponding to a frequency difference between the reference signal Cref and frequency division signal Cd, that is, a phase width, will be generated by the phase comparator 40, and the capacitive elements 61, 62 in the loop filter 60 will be charged or discharged by the charge pump 50. As a result, the voltage value of the control signal Sc will change and the frequency of the output signal Cout will be changed by the VCO 70. Thus, by the feedback loop processing of the frequency divider 30, phase comparator 40, charge pump 50, loop filter 60, and VCO 70, the control is so performed that the pulse width of the comparison signals Sup, Sdown will decrease and the frequency of output signal Cout will be switched from f1 to f2.

When the frequency division ratio 1/N of the frequency divider 30 is changed, the changeover switch 81 is switched from OFF to ON in response to the switching signal St1 from the control circuit 90. As a result, the time constant of the loop filter 60 decreases, in other words, the loop bandwidth of the loop filter 60 broadens. Therefore, the frequency of the output signal Cout can be rapidly drawn from f1 to f2.

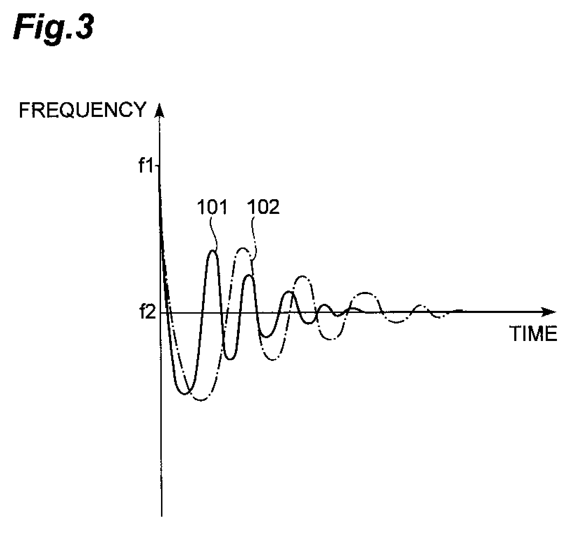

FIG. 3 shows frequency variations of the output signal during frequency switching. FIG. 3 shows a frequency draw-in characteristic 101 of the output signal Cout obtained when the changeover switch 81 is ON, that is, when the time constant of the loop filter 60 is small, and a frequency draw-in characteristic 102 of the output signal Cout obtained when the changeover switch 81 is OFF, that is, when the time constant of the loop filter 60 is large. As shown in FIG. 3, by switching ON the changeover switch 81, it is possible to draw rapidly the frequency of the output signal Cout.

After the frequency of the output signal Cout has been drawn to f2, the changeover switch 81 is switched from ON to OFF in response to the switching signal St1 from the control circuit 90. As a result, the time constant of the loop filter 60 increases, in other words, the loop bandwidth of the loop filter 60 narrows down. Therefore, spurious can be reduced.

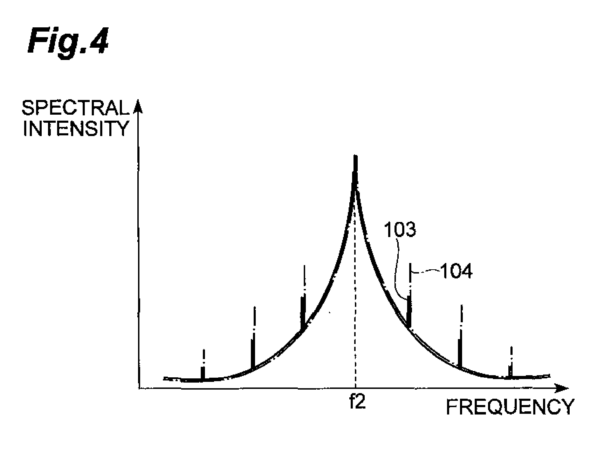

FIG. 4 shows output signal spectra. FIG. 4 shows a spectrum 103 of the output signal Cout obtained when the changeover switch 81 is OFF, that is, when the loop bandwidth of the loop filter 60 is narrow, and a spectrum 104 of the output signal Cout obtained when the changeover switch 81 is ON, that is, when the loop bandwidth of the loop filter 60 is broad. As shown in FIG. 4, by switching OFF the changeover switch 81, it is possible to reduce spurious of the output signal Cout.

In order to clarify specific features of the PLL frequency synthesizer 1 of the first embodiment, the explanation below will be conducted in comparison with an example of the conventional PLL frequency synthesizer.

[0040] The conventional PLL frequency synthesizer differs from the PLL frequency synthesizer 1 of the first embodiment in that a loop filter 60X and a switching unit 80X are provided instead of the loop filter 60 and switching unit 80.

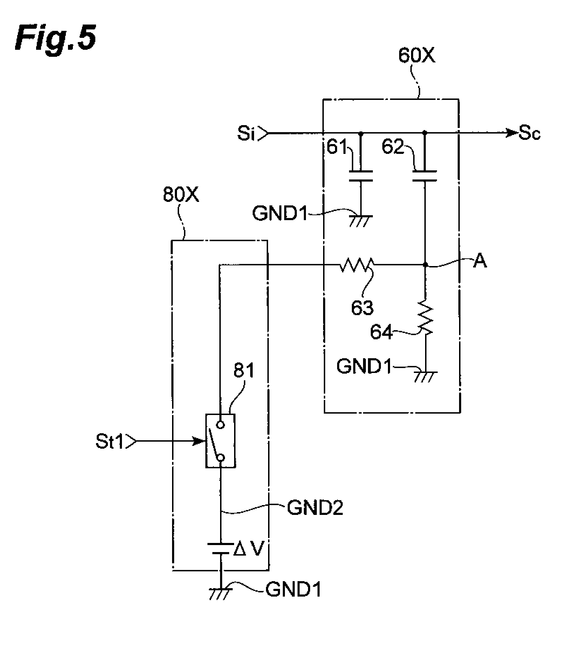

FIG. 5 shows a circuit diagram of the loop filter 60X and switching unit 80X of the conventional PLL frequency synthesizer. The loop filter 60X is different from the loop filter 60 of the first embodiment in that the capacitive element 62 and second resistive element 64 are connected in order in series between the output terminal of the charge pump 50, control terminal of the VCO 70 and the ground potential GND1 outside the semiconductor. The switching unit 80X is different from the switching unit 80 of the first embodiment in that the matching switch 82 is not provided.

The ground potential GND2 on the semiconductor substrate differs from the ground potential GND1 outside the semiconductor due to the effect of resistive components such as wiring metal or bonding wire and the semiconductor substrate (substrate). As a result, in the conventional PLL frequency synthesizer, the potential of the intermediate node A of the loop filter 60X is approximately 0 V when the changeover switch 81 is OFF, but assumes a different value of ΔV × R64/(R64 + R63) when the changeover switch 81 is ON, where ΔV stands for a difference in potential between the ground potential GND1 outside the semiconductor and the ground potential GND2 on the semiconductor substrate, and R63, R64 stand for resistance values of resistive elements 63, 64, respectively. As a result, the voltage of the control signal Sc fluctuates and the frequency of the output signal Cout fluctuates when the changeover switch 81 is switched from On to OFF.

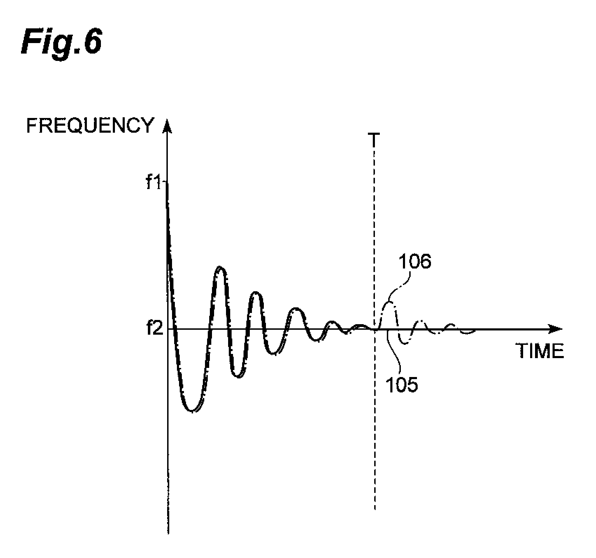

FIG. 6 shows a frequency transition in an output signal during frequency switching and after frequency switching. Thus, FIG. 6 shows a frequency transition 105 of the output signal Cout of the PLL frequency synthesizer 1 of the first embodiment and a frequency transition 106 of the output signal Cout of the conventional PLL frequency synthesizer. As shown in FIG. 6, in the conventional PLL frequency synthesizer, where the changeover switch 81 is switched from ON to OFF at a time T after the frequency of the output signal Cout has been drawn from f1 to f2, the frequency of the output signal Cout shifts from f2 due to the difference in potential ΔV between the ground potential GND2 on the semiconductor substrate and the ground potential GND1 outside the semiconductor.

After the time T, because the time constant of the loop filter 60X is large, a time is required to draw the shifted frequency to f2, and the frequency of the output signal Cout is difficult to stabilize rapidly at f2.

However, in the PLL frequency synthesizer 1 of the first embodiment, because the capacitive element 62 and second resistive element 64 are connected in order in series between the output terminal of the charge pump 50, control terminal of the VCO 70 and the ground potential GND2 wiring on the semiconductor substrate, the ground potential of the loop filter 60 becomes the potential of the group potential GND2 on the semiconductor substrate and the potential of the intermediate node A is maintained at approximately ΔV, whether the changeover switch 81 is ON or OFF. As a result, when the changeover switch 81 is switched between ON and OFF, voltage fluctuations of the control signal Sc are reduced and frequency fluctuations of the output signal Cout are reduced, as shown by the frequency transition 105 in FIG. 6.

The results obtained in simulating the voltage of the control signal Sc and voltage of the intermediate node A when the changeover switch 81 is switched in the configuration of the first embodiment provided with the loop filter 60 and switching unit 80 and the conventional configuration provided with the loop filter 60X and switching unit 80X will be explained below.

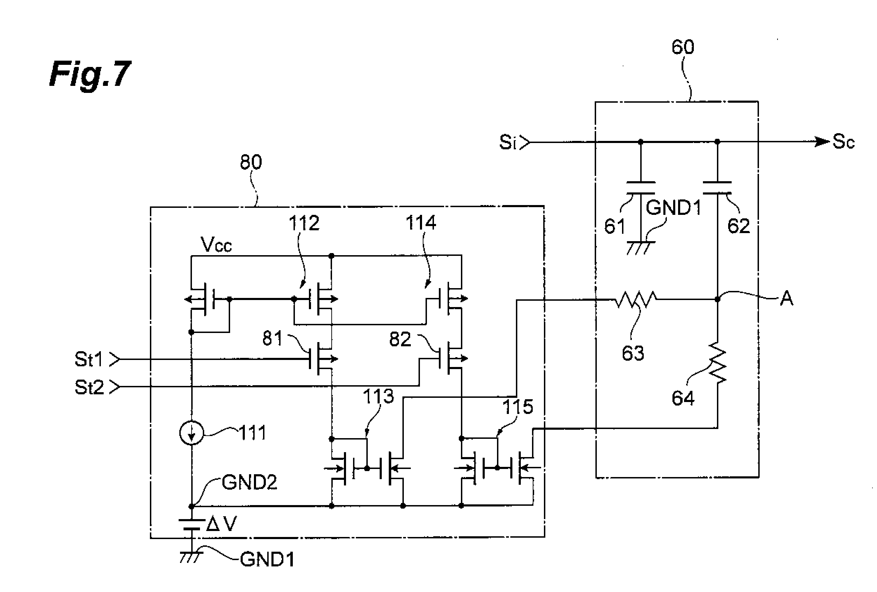

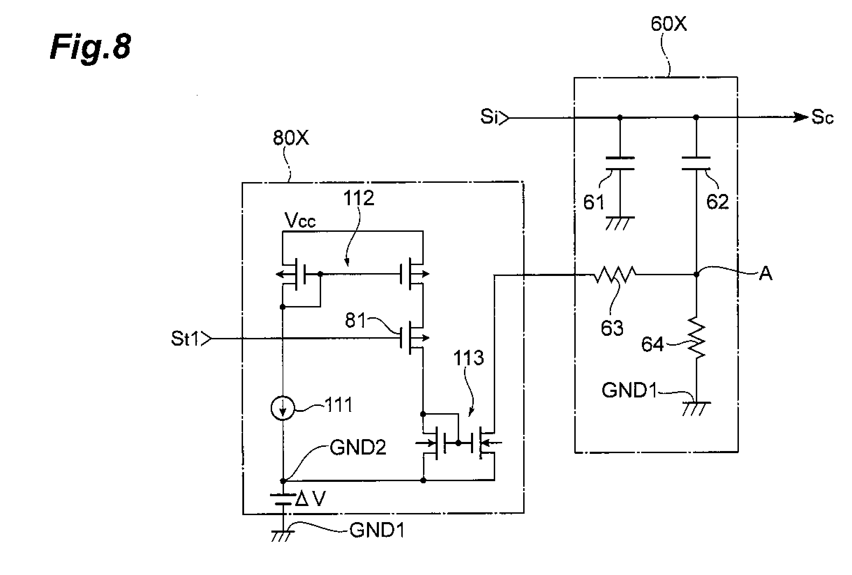

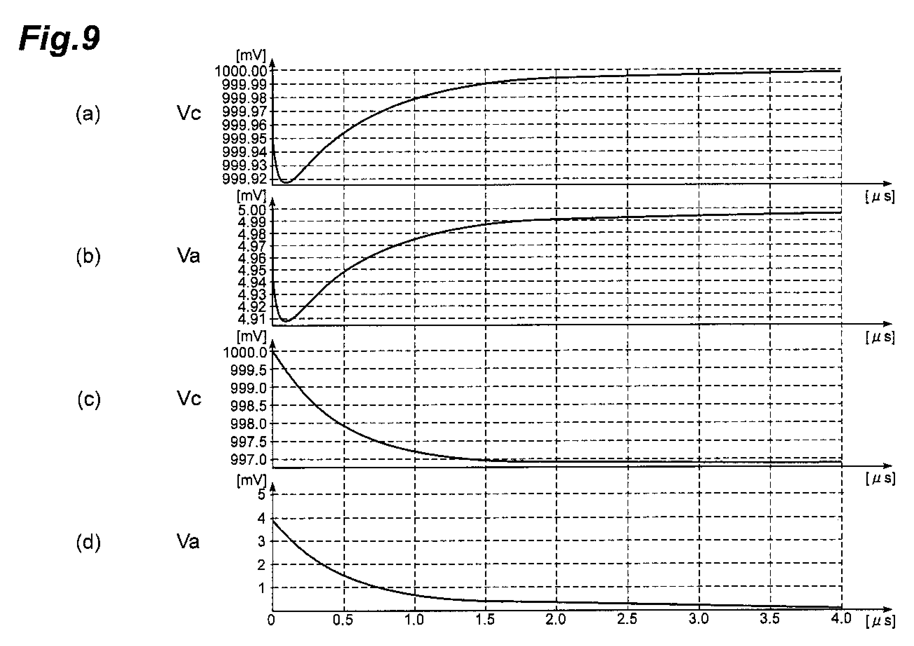

FIG. 7 is a simulation circuit of the loop filter 60 and switching unit 80 of the first embodiment, and FIG. 8 is a simulation circuit of the conventional loop filter 60X and switching unit 80X. FIG. 9 shows a signal voltage in the loop filter and changeover unit of the first embodiment and the conventional loop filter and changeover unit during switching of the changeover switch. FIGS. 9(a), (b) show respectively the voltage of the control signal Sc in the loop filter 60 and switching unit 80 of the first embodiment and the voltage Va of the intermediate node A. FIGS. 9(c), (d) show respectively the voltage of the control signal Sc in the conventional loop filter 60X and switching unit 80X and the voltage Va of the intermediate node A.

As shown in FIG. 7, in the simulation circuit of the loop filter 60 and switching unit 80 of the first embodiment, the switching unit 80 has a reference current source 111 for actuating the changeover switch 81 and matching switch 82 and current mirror circuits 112, 113, 114, and 115.

More specifically, a reference current from the reference current source 111 is supplied to the changeover switch 81 via the current mirror circuit 112, and this reference current is supplied to the capacitive element 62 and first resistive element 63 via the current mirror circuit 113 in response to ON/OFF of the changeover switch 81. Likewise, a reference current from the reference current source 111 is supplied to the matching switch 82 via the current mirror circuit 114, and this reference current is supplied to the capacitive element 62 and second resistive element 64 via the current mirror circuit 115.

[0050] Further, as shown in FIG. 8, in the simulation circuit of the conventional loop filter 60X and switching unit 80X, the switching unit 80X has a reference current source 111 for actuating the changeover switch 81 and current mirror circuits 112, 113. More specifically, a reference current from the reference current source 111 is supplied to the changeover switch 81 via the current mirror circuit 112, and this reference current is supplied to the capacitive element 62 and first resistive element 63 via the current mirror circuit 113 in response to ON/OFF of the changeover switch 81.

FIG. 9 shows the simulation results obtained in the simulation circuit shown in FIG. 7 and FIG. 8 in the case where the resistance value R63 of the first resistive element 63 is 820 Ω, the resistance value R64 of the second resistive element 64 is 3 kΩ, the initial voltage of the control terminal of the VCO 70 is 1 V, and the difference in potential ΔV between the ground potential GND2 on the semiconductor substrate and the ground potential GND1 outside the semiconductor is 5 mV.

As shown in FIG. 9, in the conventional loop filter 60X and switching unit 80X, when the changeover switch 81 is switched from ON to OFF, because the difference in potential between the ground potential GND2 on the semiconductor substrate and the ground potential GND1 outside the semiconductor is ΔV = 5 mV, the voltage Va of the intermediate node A of the loop filter 60X changes by about 3.756 mV from 3.901 mV (during switching) to 0.145 mV (4 µs after switching) (FIG. 9(d)). As a result, the voltage of the control signal Sc changes by about 3.183 mV from 1.000000 V (during switching) to 0.996817 V (4 µs after switching) (FIG. 9(c)).

In the VCO 70 in which the frequency of the output signal Cout changes by 45 MHz when the voltage of the control signal Sc changes by 1 V, where the voltage of the control signal Sc changes by about 3.183 mV, the frequency of the output signal Cout changes by about 143.235 kHz. The problem is that, for example, in a TDMA system in which the difference in frequency between the channels is 200 kHz, the frequency of the output signal Cout also changes by about 143.235 kHz.

In the loop filter 60 and switching unit 80 of the first embodiment, when the changeover switch 81 is switched from ON to OFF, the ground potential of the loop filter 60 does not change and remain at a reference level GND2 on the semiconductor substrate. Therefore, the voltage Va of the intermediate node A of the loop filter 60 changes only by about 0.003 mV from 5.000 mV (during switching) to 4.997 mV (4 µs after switching) (FIG. 9(b)). As a result, it is clear that the voltage of the control signal Sc changes only by about 0.002 mV from 1.000000 V (during switching) to 0.999998 V (4 µs after switching) (FIG. 9(a)). Therefore, frequency fluctuations of the output signal Cout are reduced to about 0.090 kHz.

Thus, with the PLL frequency synthesizer 1 of the first embodiment, the ground potential of the loop filter 60 becomes the ground potential GND2 on the semiconductor substrate whether the changeover switch 81 is OFF or ON. Therefore, when the changeover switch 81 is ON/OFF switched, voltage fluctuations of the control signal Sc can be reduced and frequency fluctuations of the output signal Cout can be reduced. Therefore, frequency switching can be performed rapidly, and in a stationary state, noise such as spurious can be reduced.

Further, with the PLL frequency synthesizer 1 of the first embodiment, the impedance of the matching switch 82 is substantially equal to the impedance of the changeover switch 81. Therefore, the voltage drop in the changeover switch 81 is substantially equal to the voltage drop in the matching switch 82. Thus, when the changeover switch 81 is ON/OFF switched, voltage fluctuations in the intermediate node A in the loop filter 60 and of the control signal Sc can be further reduced, and frequency fluctuations of the output signal Cout can be further reduced.

### [Second Embodiment]

A PLL frequency synthesizer 1A of the second embodiment of the present invention will be described below. As shown in FIG. 1, the configuration of the PLL frequency synthesizer 1A differs from that of the PLL frequency synthesizer 1 of the first embodiment in that the former has a loop filter 60A and switching unit 80A instead of the loop filter 60 and switching unit 80 of the latter. Other features of the PLL frequency synthesizer 1A are identical to those of the PLL frequency synthesizer 1.

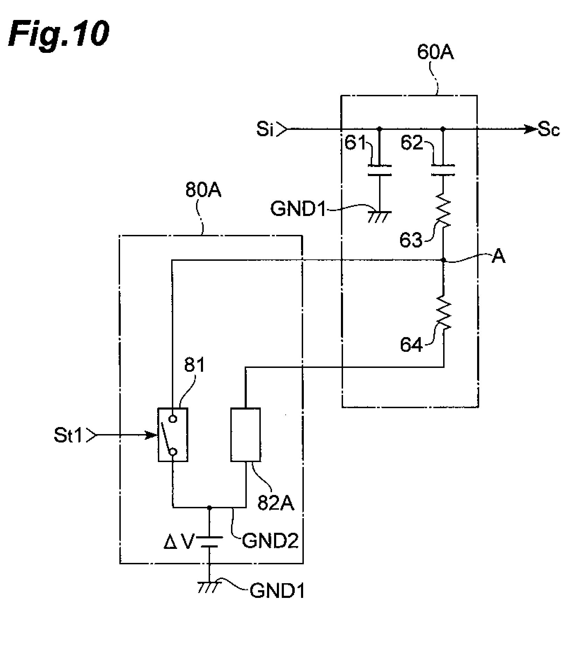

FIG. 10 is a circuit diagram illustrating the loop filter and changeover switch of the second embodiment. The loop filter 60A differs from the loop filter 60 of the first embodiment in that the capacitive element 62, first resistive element 63, and second resistive element 64 are connected in order in series between the output terminal of the charge pump 50, control terminal of the VCO 70, and switching unit 80, and in that the intermediate node A between the capacitive element 62 and second resistive element 64 are connected directly to the switching unit 80. Other features of the loop filter 60A are identical to those of the loop filter 60.

The switching unit 80A differs from the switching unit 80 of the first embodiment in that a matching impedance element 82A is provided instead of the matching switch 82. Other features of the switching unit 80A are identical to those of the switching unit 80.

The impedance of the matching impedance element 82A is substantially equal to the impedance of the changeover switch 81. The resistive elements, capacitive elements, inductors, synthesizer circuits thereof, and wiring metal having functions thereof can be applied to the matching impedance element 82A.

Thus, the advantages similar to those obtained with the PLL frequency synthesizer 1 of the first embodiment can be also obtained in the PLL frequency synthesizer 1A of the second embodiment.

The present invention is not limited to the above-described embodiments and can be variously changed.

The configurations of the embodiments are provided with the matching switch 82 or matching impedance element 82A, but the effect of reducing the fluctuations caused by the difference between ground potentials can be also obtained with a configuration in which the second resistive element 64 and the ground potential GND2 wiring on the semiconductor substrate are directly connected by a wiring, without providing the matching switch 82 and matching impedance element 82A.

### Industrial Applicability

Applications are possible to a field in which frequency switching is rapidly performed due to the reduction in frequency fluctuations during bandwidth switching of a loop filter.

## Claims

1. A PLL frequency synthesizer, comprising:
a voltage controlled oscillator;
a frequency divider that frequency divides an output of the voltage controlled oscillator;
a phase comparator that inputs an output signal of the frequency divider and a reference signal;
a charge pump that generates a charge-discharge current in response to an output signal of the phase comparator;
a loop filter that is connected between an output terminal of the charge pump and a control terminal of the voltage controlled oscillator and has a reference potential on a semiconductor substrate as a ground potential; and
a changeover switch that is formed on the semiconductor substrate and switches connection between an intermediate node of the loop filter and the reference potential on the semiconductor substrate in order to switch a time constant of the loop filter.

2. The PLL frequency synthesizer according to claim 1, wherein
the loop filter comprises a first resistive element, and a capacitive element and a second resistive element that are connected in order in series between an output terminal of the charge pump and a reference potential wiring on the semiconductor substrate;
the first resistive element is connected in series to the changeover switch; and
a series circuit of the first resistive element and the changeover switch is connected in series between the intermediate node, located between the capacitive element and the second resistive element, and the reference potential wiring on the semiconductor substrate.

3. The PLL frequency synthesizer according to claim 1, wherein
the loop filter has a capacitive element, a first resistive element, and a second resistive element connected in order in series between an output terminal of the charge pump and a reference potential wiring on the semiconductor substrate; and
the changeover switch is connected in series between the intermediate node, located between the first resistive element and the second resistive element, and the reference potential wiring on the semiconductor substrate.

4. The PLL frequency synthesizer according to claim 2 or 3, further comprising a matching switch that is formed on the semiconductor substrate and connected in series between the second resistive element and the reference potential wiring on the semiconductor substrate, wherein
an impedance of the matching switch is substantially equal to an impedance of the changeover switch.

5. The PLL frequency synthesizer according to claim 4, wherein
the changeover switch and the matching switch are transistors; and
a transistor size of the matching switch is equal to a transistor size of the changeover switch.

6. The PLL frequency synthesizer according to claim 2 or 3, further comprising a matching impedance element that is formed on the semiconductor substrate and connected in series between the second resistive element and the reference potential wiring on the semiconductor substrate, wherein
an impedance of the matching impedance element is substantially equal to an impedance of the changeover switch.
